# EUROPÄISCHE PATENTANMELDUNG

(11) **EP 3 064 608 A1**
(43) Veröffentlichungstag der Anmeldung: **07.09.2016**
(21) Anmeldenummer: 16151272.8
(22) Anmeldetag: 14.01.2016
(51) Int. Cl.: C23C 14/04, C23C 4/02, C23C 16/04, F01D 5/28, F16J 15/02, F16J 15/14

(54) **VORRICHTUNG UND VERFAHREN ZUM PARTIELLEN ABDECKEN EINER BAUTEILZONE EINES BAUTEILS**

(30) Priorität: 03.03.2015 DE 102015203729
(71) Anmelder: MTU Aero Engines AG, 80995 München (DE)
(72) Erfinder: Uihlein, Thomas, 85221 Dachau (DE); Stolle, Ralf, 82515 Wolfratshausen (DE); Kähny, Andreas, 82275 Emmering (DE); Lachner, Josef, 85305 Jetzendorf Kemmoden (DE); Walter, Heinrich, 86316 Friedberg (DE); Straßer, Michael, 85253 Kleinberghofen (DE); Moosrainer, Werner, 85254 Sulzemoos/Orthofen (DE); Schober, Michael, 80999 München (DE)

(57) **Zusammenfassung**

Die Erfindung betrifft ein Verfahren und eine Vorrichtung zum paitiellen Abdecken eines Bauteils (16) oder einer Bauteilgruppe bei einem Beschichtungsprozess, wobei die Vorrichtung mindestens eine Abdeckplatte (4, 4', 4") zur Trennung eines zu beschichtenden Bereichs (26) von einem abzudeckenden Bereich (24) umfasst, wobei die Abdeckplatte (4, 4', 4") mindestens einen Teil mindestens einer zum Bauteil (16) konturnahen Öffnung (14) zum Durchführen des Bauteils (16) aufweist. Dabei ist im Abdeckbereich (12) entlang der Öffnung (14) ein Spalt (R_{S}) vorhanden, an dem abdeckbereichsseitig mindestens ein Dichtungselement (28, 30; 46) angeordnet ist.

## Beschreibung

Die Erfindung betrifft eine Vorrichtung zum partiellen Abdecken eines zu beschichtenden Bauteils sowie ein entsprechendes Verfahren.

Unterschiedliche Bauteilabschnitte von beispielsweise Gasturbinenschaufeln erfordern unterschiedliche Arten und Dicken an Schutzbeschichtungen, und auf einigen Abschnitten darf sich keine Beschichtung befinden, da sonst die Festigkeit des Bauteils drastisch sinkt. Die Aufbringung der unterschiedlichen Arten und Dicken von Schutzbeschichtungen in einigen Bereichen und die Verhinderung einer Beschichtungsabscheidung in anderen Bereichen kann bei Anwendung der effizientesten Beschichtungstechniken schwierige Probleme für solche Bauteile bereiten, welche neu hergestellt oder repariert werden, und welche bereits bestehende Beschichtungen aufweisen und/oder neu aufgebrachte Beschichtungen benötigen. In vielen Fällen ist es schwierig, die gewünschte Kombination von Schutzbeschichtungen und unbeschichteten Oberflächen zu erzielen.

Ferner dürfen Schaufelblätter wegen hoher lokaler mechanischer Belastungen nur in Teilbereichen beschichtet werden, wo die limitierte Dehnfähigkeit der Erosionsschutzbeschichtung kein mechanisches Risiko darstellt. Dies erfordert eine lokale Abdeckvorrichtung, die an das jeweilige Schaufelblatt angepasst werden muss. Die zunehmende Komplexität der 3D-Schaufelblattgestaltung und die erschwerte Zugänglichkeit bei Blisken erhöht den Aufwand bei den Abdeckungen. Insbesondere sind die Toleranzen bei den Beschichtungen von Schaufelblättern sehr eng definiert. Nicht nur müssen die Schichtdicken korrekt sein, sondern die Beschichtungen dürfen nur dort aufgebracht sein, wo dies erlaubt ist.

In der Druckschrift DE 10 2008 053 394 A ist beispielsweise eine solche Abdeckvorrichtung offenbart. Um das zu bearbeitende Bauteil wird eine Abdeckplatte angeordnet. Zwischen dem Bauteil und der Abdeckplatte ist ein Spalt vorhalten. In den Spalt wird ein Filz bzw. eine Bürstendichtung angeordnet, die sich der Kontur des Bauteils anpasst ohne das Bauteil zu beschädigen.

Dabei ist es insbesondere nachteilig, dass der Metallfilz für die Dampfphase der abzuscheidenden Metallatome und Ionen durchlässig ist und im nicht zu beschichtenden Nahbereich trotzdem noch eine unkontrollierte atomare Beschichtungszone auf der Oberfläche des Schaufelblatts entsteht. Diese atomare Beschichtungszone muss nach dem Beschichten mühsam mechanisch nachgearbeitet werden. Dies ist zeit- und kostenintensiv. Ferner kann durch die mechanische Nachbearbeitung das Bauteil beschädigt werden.

Somit liegt der vorliegenden Erfindung die Aufgabe zu Grunde ein Verfahren und eine Vorrichtung vorzustellen, die die oben beschriebenen Nachteile vermeidet.

Die Aufgabe wird durch die Merkmale des Anspruchs 1 gelöst. Die Aufgabe wird ferner durch die Merkmale des Anspruchs 10 gelöst.

Die Erfindung betrifft eine Vorrichtung zum partiellen Abdecken eines Bauteils oder einer Bauteilgruppe bei einem Beschichtungsprozess, wobei die Vorrichtung mindestens eine Abdeckplatte zur Trennung eines zu beschichtenden Bereichs von einem abzudeckenden Bereich umfasst, wobei die Abdeckplatte mindestens einen Teil mindestens einer zum Bauteil konturnahen Öffnung zum Durchführen des Bauteils aufweist.
Dabei ist im Abdeckbereich (12) entlang der Öffnung (14) ein Spalt (Rₛ) vorhanden, an dem abdeckbereichsseitig mindestens ein Dichtungselement (28, 30; 46) angeordnet ist. Abdeckbereichsseitig bedeutet, dass das Dichtungselement nicht in dem Spalt bzw. der Öffnung sondern von einer Seite, nämlich der nicht zu beschichtenden, abgedeckten Seite aus vor der Öffnung bzw. dem resultierenden Spalt angeordnet ist.
Das Dichtungselement kann also direkt an der Öffnung hinter der Abdeckplatte angeordnet sein. Das Dichtungselement ist also nicht direkt in der Öffnung angeordnet. "Hinter der Abdeckplatte" bezieht sich somit auf den abzudeckenden Bereich bzw. den Abdeckbereich. Vorzugsweise ist die Öffnung konturnah zum Bauteil geformt. Eine konturnahe Öffnung ist beispielsweise dann gegeben, wenn der Abstand zwischen der Öffnung und dem Bauteil über den Umfang konstant ist, d.h. die Öffnung folgt der Kontur des Bauteils.

Die Vorrichtung vermeidet in vorteilhafter Weise unerwünschte harte Beschichtungsübergänge, d.h. dass der beschichtete Bereich zum unbeschichteten Bereich in der Schichtdicke graduell abnimmt und nicht stufenartig aufgebaut ist, denn solche Beschichtungsstufen fördern die Rissentstehung und Rissfortbreitung.

In einer weiteren vorteilhaften Ausgestaltung der Erfindung ist der Spalt zwischen der Öffnung und dem Bauteil so geformt und bemessen, dass das Dichtungselement nicht durch den Spalt passt. Dies ist insbesondere vorteilhaft, da dadurch verhindert wird, dass das Dichtungselement, wie Gleitschleifsteine, Mahlkugeln oder ähnliches nicht in den Spalt rieseln kann und den zu beschichtenden Bereich in unerwünschter Weise teilweise abdeckt. Bei beispielsweise kugelförmigen Dichtungselementen ist der Randspalt Rₛ kleiner als der Kugeldurchmesser d.

In einer weiteren vorteilhaften Ausgestaltung der Erfindung ist das Dichtungselement kugelförmig, zylindrisch, pyramiden-förmig, kegelförmig, kissenförmig und/oder ringförmig. Die pyramiden-förmigen Dichtungselemente können eine dreieckige oder viereckige Grundfläche aufweisen. Generell gilt, dass die Grundfläche der einzelnen Dichtungselemente nicht senkrecht zur Höhe verlaufen muss. So können beispielsweise die Enden der zylinderförmigen Dichtungselemente schräg zur Zylindermittelachse geschnitten sein. Je nach Beschichtungstyp und Ergebnis wird die entsprechende Form ausgewählt.

In einer weiteren vorteilhaften Ausgestaltung der Erfindung ist das Dichtungselement hohl. Dieses Dichtungselement ist vorzugsweise gasdicht, so dass die im Dichtungselement eingeschlossene Luft sich unter Vakuum ausdehnen kann. Wird beispielsweise ein einziges ringförmiges Dichtungselement um das Bauteil gelegt, so dehnt sich dieses Dichtungselement unter Vakuum aus und schmiegt sich gegen die Oberfläche des Bauteils an, ohne das Bauteil zu beschädigen. Alternativ oder in Kombination können die Dichtungselemente kissenförmig sein. Diese hohlen Kissen werden dann um das Bauteil angeordnet. Auch können die Dichtungselemente beispielsweise hohle Kugel sein, die um das Bauteil geschüttet und fixiert werden. Durch das Vakuum können die hohlen Kugeln sich ausdehnen und die Lücken zwischen den Kugeln verkleinern, so dass verhindert wird, dass das Beschichtungsmaterial in unerwünschter Weise an den Kugeln vorbeigelangen kann.

In einer weiteren vorteilhaften Ausgestaltung der Erfindung beträgt die Dicke der Hülle des hohlen Dichtungselementes zwischen 100µm und 1mm. Vorzugsweise wird als Hüllenmaterial Metall verwendet, da es dehnungsfähig und temperaturbeständig ist. Die Hüllendicke beeinflusst die Ausdehnung des Dichtungselements unter Vakuum.

In einer weiteren vorteilhaften Ausgestaltung der Erfindung ist das Dichtungselement aus Metall, Keramik und/oder Kunststoff. Das Dichtungselement muss Temperaturen von 300 bis 450 °C aushalten können. Als Keramik wird vorzugsweise Aluminiumoxid mit Siliziumoxid verwendet. Typischerweise in einem Mischungsverhältnis von 90Vol% - Al und 10 Vol% SiO₂.

In einer weiteren vorteilhaften Ausgestaltung der Erfindung liegt die Abmessung des Dichtungselement zwischen 1,0 bis 10mm. Vorzugsweise werden Kugeln mit einem Durchmesser von 1,2 bis 1,3 mm als Dichtungselemente verwendet. Andere Kugeln mit einem Durchmesser von 2,5 bis 3,5 können alternativ oder in Kombination verwendet werden. In Abhängigkeit vom Spalt sind auch größere Kugeln denkbar.

In einer weiteren vorteilhaften Ausgestaltung der Erfindung weist die Vorrichtung ein um das Dichtungselement angeordnetes Halteelement auf, wobei das Halteelement im Abdeckbereich angeordnet ist. Dies ist insbesondere vorteilhaft, wenn Schüttgut wie Gleitschleifsteine oder Mahlkugeln als Dichtungselemente verwendet werden, da gezielt die Dichtungselemente um das Bauteil angeordnet werden können. Somit kann die Anzahl der verwendeten Dichtungselemente möglichst klein gehalten werden. Bei einem hohlen Dichtungselement bzw. mehreren hohlen Dichtungselementen können sich beim Ausdehnen diese gegen das Halteelement drücken, so dass der Dichtungsdruck am Bauteil größer wird und dort den Spalt zwischen der Abdeckplatte und dem Bauteil besser abdichtet.

In einer weiteren vorteilhaften Ausgestaltung der Erfindung bilden mindestens zwei Abdeckplatten mindestens eine Öffnung für das Bauteil. Dies hat den Vorteil, dass das Bauteil nicht durch die Öffnung der Abdeckplatte gefädelt werden muss. Stattdessen können beispielsweise bei einer Blisk (bladed disk) die Abdeckplatten zwischen den Schaufellücken angeordnet werden. Dabei kann an den beiden gegenüberliegenden Kanten der Abdeckplatte einen halben Ausschnitt einer Öffnung aufweisen. Damit bilden zwei benachbart angeordnete Abdeckplatte an ihren anstoßenden Kanten gemeinsam eine Öffnung für das Bauteil.

Ferner betrifft die Erfindung ein Verfahren zum partiellen Abdecken einer Bauteilzone eines Bauteils. Zuerst wird das Bauteil (16) in eine zum Bauteil (16) konturnahen Öffnung (14) mindestens einer Abdeckplatte (4, 4', 4"), die einen zu beschichtenden Bereich (26) von einem abzudeckenden Bereich (24) trennt platziert, so dass die Öffnung einen minimalen Spalt (Rₛ) aufweist. Dann wird mindestens ein Dichtungselement (28, 30; 46) im Abdeckbereich in der Nähe der Öffnung (14) platziert, so dass der Spalt (Rₛ) bzw. die Öffnung einseitig verschlossen ist, und dann wird der zu beschichtende Bereich (26) beschichtet.

In einer weiteren vorteilhaften Ausgestaltung der Erfindung erfolgt das Beschichten per PVD (physical vapor deposition), per CVD (chemical vapor deposition) und/oder per thermischen Spritzen.

In einer weiteren vorteilhaften Ausgestaltung der Erfindung wird vor dem Beschichten um das Dichtungselement ein Halteelement angeordnet.

In einer weiteren vorteilhaften Ausgestaltung der Erfindung wird vor dem Beschichten ein Vakuum aufgebaut. Damit können sich hohle und gasdichte Dichtungselemente unter diesen Bedingungen auszudehnen.

Weitere vorteilhafte Ausgestaltung der Erfindung sind in den Unteransprüchen wiedergegeben.

Im Weiteren werden anhand der schematischen Zeichnung bevorzugte Ausführungsbeispiele der Erfindung näher beschrieben. Dabei zeigen:
- Figur 1: einen Schnitt durch eine erfindungsgemäße Vorrichtung,
- Figur 2: eine Vergrößerung des strichpunktierten Bereichs in Figur 1,
- Figuren 3, 4: eine Schrägansicht auf mehrere Abdeckplatten,
- Figur 5: einen Schnitt durch eine alternative erfindungsgemäße Vorrichtung, und
- Figur 6: einen Schnitt entlang der Linie IV-IV in Figur 5.

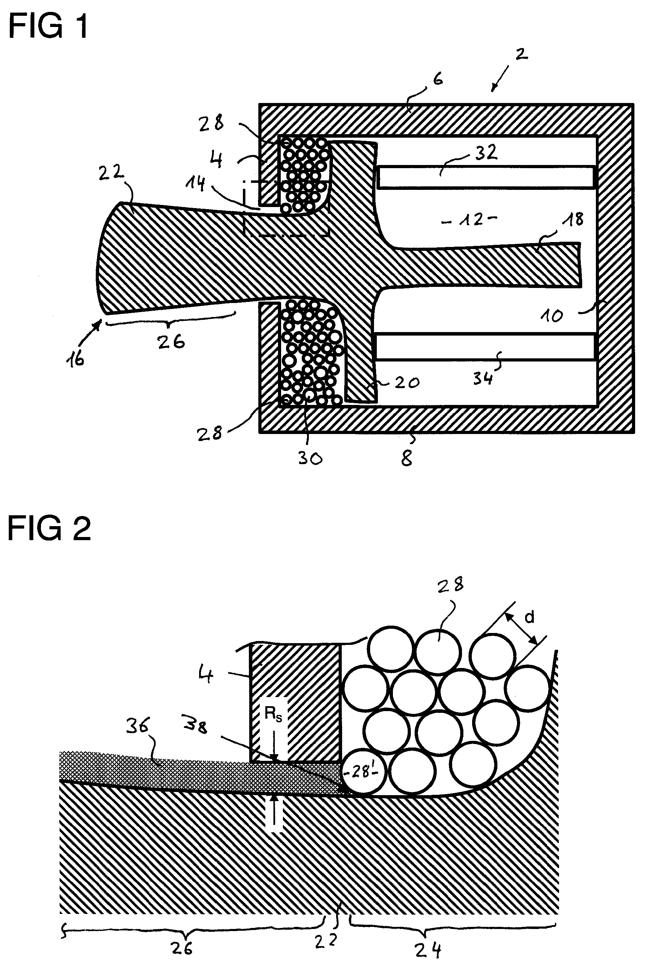

Die Figur 1 zeigt einen Schnitt durch einen Abdeckbehälter 2 mit einer Abdeckplatte 4, zwei Seitenwänden 6 und 8 und eine Bodenplatte 10, wobei der Abdeckbehälter 2 einen Hohlraum 12 umschließt. In der Abdeckplatte 4 ist eine Öffnung 14 eingelassen. Ein Teil eines Bauteils 16 ist innerhalb des Hohlraums 12 angeordnet. Hier ist als Bauteil insbesondere eine Laufschaufel bzw. eine Leitschaufel 16 zu sehen. So ist der Schaufelfuß 18 und das Innendeckband 20, das innere Teil 24 des Schaufelblattes 22 im Hohlraum 12 angeordnet. Das Schaufelblatt 22 geht durch die Öffnung 14, so dass der obere Teil 26 des Schaufelblattes 22 außerhalb des Hohlraums 12 angeordnet ist. Der Hohlraum 12 stellt den sogenannten nicht zu beschichtenden Bereich dar. Dies ist in der Figur 1 der Bereich rechts von der Abdeckplatte 4. Links von der Abdeckplatte 4 und in der Öffnung 14 befindet sich der sogenannte zu beschichtende Bereich des Bauteils 16.

Oberhalb des Schaufelblattes 22 zwischen der Abdeckplatte 4 (rechts davon), dem radial unteren Teil 24 des Schaufelblattes 22 (in der Figur 1 der rechte Bereich des Schaufelblattes), dem Innendeckband 20 und einem Teil der Seitenwand 6 sind in einer ersten Ausführungsform als Dichtungselemente Kugeln 28 mit gleichem Durchmesser angeordnet. In der Figur 1 unterhalb des Schaufelblattes 22 zwischen der Abdeckplatte 4 (rechts davon), dem radial unteren Teil 24 des Schaufelblattes 22, dem Innendeckband 20 und einem Teil der Seitenwand 6 sind in einer zweiten Ausführungsform als Dichtungselemente Kugeln 28 und 30 mit unterschiedlichen Durchmessern angeordnet. Die beiden Ausführungsformen können alternativ oder wie in Figur 1 in Kombination verwendet werden.

Damit die Dichtungselemente 28 und 30 die Laufschaufel 16 innerhalb des Abdeckbehälters 2 nicht verschieben, sind im Hohlraum 12 beispielsweise zwei Halteelemente 32 und 34 angeordnet, die hier gegen die Unterseite des Innendeckbandes 20 und der Bodenplatte 10 drücken und die Laufschaufel 16 im Abdeckbehälter 2 fixiert.

Die Figur 2 zeigt eine Vergrößerung des strichpunktierten Ausschnitts aus Figur 1. Im oberen Bereich der Figur 2 ist ein Teil der Abdeckplatte 4 zu sehen. Rechts davon ist ein Teil des Innendeckbandes 20 der Schaufel 16 sichtbar. Dazwischen sind die kugelförmigen Dichtungselemente 28 und 28' angeordnet, die auf dem radial unteren Teil 24 des Schaufelblattes 22 liegen. Zwischen der Oberfläche des Schaufelblattes 22 und der Abdeckplatte 4 ist ein Spalt bzw. Randspalt Rₛ vorhanden. Direkt am Ende der Öffnung 14 bzw. am Randspalt Rₛ ist eine Kugel 28' gegen die Abdeckplatte 4 und dem unteren Teil 24 des Schaufelblattes 22 angeordnet. Es ist anzumerken, dass die Positionierung der Kugeln zufällig durch das Einschütten erfolgt. Daher ist die Darstellung in Figur 2 nur als Beispiel zu verstehen. Beim Beschichten entsteht auf der Oberfläche des Schaufelblattes 22 eine Beschichtung 36, die bis zur Kugel 28' reicht. Die Beschichtung 36 erhält dadurch als Abschluss einen Übergangskeil 38. Die Schichtdicke reduziert sich bereits im Bereich um die Abdeckplatte 4.

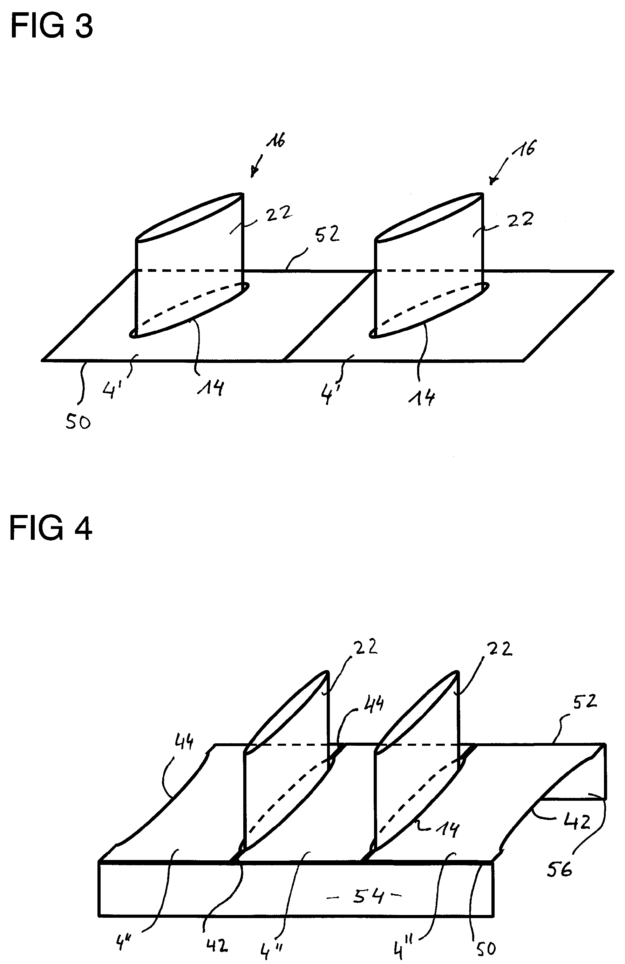

Die Figur 3 zeigt eine Schrägansicht auf zwei Schaufeln 16, die mittels zwei Abdeckplatten 4' abgedeckt sind. Jede der Abdeckplatten 4' weist eine Öffnung 14 auf, durch die das entsprechende Schaufelblatt 22 durchgefädelt ist.

Die Figur 4 zeigt eine Schrägansicht auf zwei Schaufeln 16, die mittels drei Abdeckplatten 4" abgedeckt sind. Jede Abdeckplatte 4" weist eine (hier) rechte Kante 42 und eine zur rechten Kante 42 gegenüberliegende (hier) linke Kante 44 auf, die einen Teil der Öffnung 14 bilden. Somit bildet in der Figur 4 die rechte Kante 42 der linken Abdeckplatte 4" mit der linken Kante 44 der mittleren Abdeckplatte 4" die linke Öffnung 14, in der sich das Schaufelblatt 22 befindet. Diese Ausführungsform hat den Vorteil, dass die Abdeckplatten 4" bei einer Blisk einfach zwischen den Schaufelblättern 22 positioniert werden können und geeignet befestigt werden können. Denkbar, jedoch nicht in der Abbildung gezeigt, könnte hier auch eine zusätzliche Trennung, beispielsweise entlang des Dichtungskissens 44 vorgesehen sein, um hier eine weitere Trennung und somit Abdeckung bei komplexeren 3D-Geometrien zu erwirken.

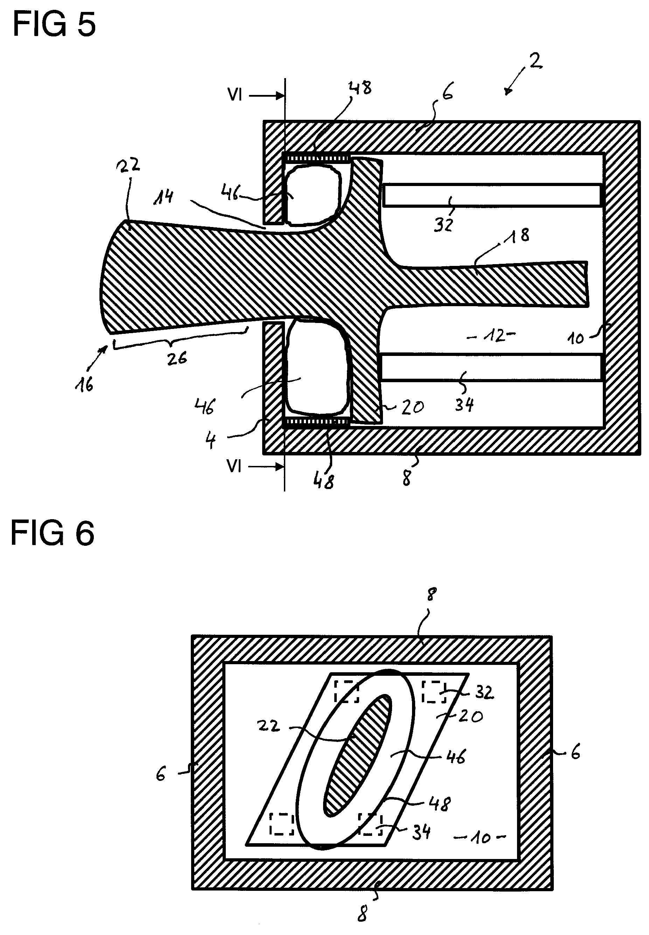

Die Figur 5 zeigt einen Schnitt durch eine dritte Ausführungsform einer erfindungsgemäßen Vorrichtung. Die Figur 6 zeigt einen Schnitt entlang der Linie VI-VI in Figur 5. Im Folgenden werden nur die Unterschiede zu den beiden ersten Ausführungsform der Figur 1 beschrieben.

Oberhalb und unterhalb des Schaufelblattes 22 zwischen der Abdeckplatte 4 (in der Figur 5 rechts davon), dem unteren Teil 24 des Schaufelblattes 22, dem Innendeckband 20 und einem Teil der Seitenwände 6 und 8 sind in dieser dritten Ausführungsform als Dichtungselement ein ringförmiger und hohler Dichtungskissen 46 angeordnet. Dieser Dichtungskissen 46 weist eine metallische Hülle auf, um gegenüber den bei der Beschichtung auftretenden Temperaturen standzuhalten. Um das Dichtungskissen 46 kann ein Halteelement 48 angeordnet sein, so dass das Dichtungskissen formnah an das Schaufelblatt 22 angeordnet ist. Insbesondere hilft das Halteelement 48 den Druck des Dichtungskissen auf das Schaufelblatt 22 aufzubauen, da dass Dichtungskissen 46 außen vom Halteelement fixiert wird und somit nur nach innen ausweichen kann. Dadurch wird der Randspalt Rₛ auf der Seite des Hohlraums 12 abgedichtet.

Das Halteelement 48 kann auch in den beiden Ausführungsformen der Figur 1 verwendet werden. Statt Vollkugeln werden Hohlkugeln verwendet, die sich, wie das Dichtungskissen 46, im Vakuum ausdehnen.

Die in den Figuren 1, 5 und 6 gezeigten Abdeckbehälter sind vorzugsweise für Einzelschaufeln geeignet. Sollen dagegen mehrere Schaufeln einer Blisk beschichtet werden, so werden lediglich die Abdeckplatten 4' bzw 4" verwendet. Zur seitlichen Abgrenzung des unteren Bereichs 24 eines Schaufelblatts 22 wird zuerst an den vorderen Kanten 50 (siehe Figur 3) der Abdeckplatten 4" ein vorderer (segmentierter) Ring bzw. Scheibe 54 (siehe Figur 4) angebracht. Der Bereich zwischen den Abdeckplatten 4' bzw 4" und den Innendeckbändern 20 wird mit mehreren Dichtungselementen (z.B. Kugeln 28) befüllt. Anschließend wird der hintere (segmentierte) Ring bzw. Scheibe 56 an den hinteren Kanten 52 angebracht. Die abgedeckte Blisk wird dann in die Beschichtungskammer platziert. In dieser Kammer wird ein Vakuum aufgebaut und dann werden die freien Oberflächen der Bliskschaufelblätter beschichtet.

Grundsätzlich ist es auch bevorzugt, die beiden Scheiben (54, 56) anzubringen, den Hohlraum zu verfüllen und anschließend die Abdeckplatten (4', 4") aufzubringen.

### Bezugszeichenliste

- 2: Abdeckbehälter
- 4; 4'; 4": Abdeckplatte
- 6: Seitenwand
- 8: Seitenwand
- 10: Bodenplatte
- 12: Hohlraum
- 14: Öffnung
- 16: Bauteil (Laufschaufel)
- 18: Schaufelfuß
- 20: Innendeckband
- 22: Schaufelblatt
- 24: untere Teil des Schaufelblatts
- 26: obere Teil des Schaufelblatts
- 28: Kugel mit einem Durchmesser
- 30: Kugeln mit einem anderen Durchmesser
- 32: Halteelement
- 34: Halteelement
- 36: Beschichtung
- 38: Übergangskeil
- 42: rechte Kante
- 44: linke Kante
- 46: Dichtungskissen
- 48: Halteelement
- 50: vordere Kante
- 52: hintere Kante
- 54: vorderer Ring bzw. Scheibe
- 56: hinterer Ring bzw. Scheibe
- d: Kugeldurchmesser
- Rₛ: Randspalt

## Patentansprüche

1. Vorrichtung zum partiellen Abdecken eines Bauteils (16) oder einer Bauteilgruppe bei einem Beschichtungsprozess, wobei die Vorrichtung mindestens eine Abdeckplatte (4, 4', 4") zur Trennung eines zu beschichtenden Bereichs (26) von einem abzudeckenden Bereich (24) umfasst, wobei die Abdeckplatte (4, 4', 4") mindestens einen Teil mindestens einer zum Bauteil (16) konturnahen Öffnung (14) zum Durchführen des Bauteils (16) aufweist,
**dadurch gekennzeichnet, dass**
im Abdeckbereich (12) entlang der Öffnung (14) ein Spalt (Rₛ) vorhanden ist, an dem abdeckbereichsseitig mindestens ein Dichtungselement (28, 30; 46) angeordnet ist.

2. Vorrichtung nach Anspruch 1, **dadurch gekennzeichnet, dass** der Spalt (Rₛ) zwischen der Öffnung (14) und dem Bauteil (16) so geformt und bemessen ist, dass das Dichtungselement (28, 30; 46) nicht durch den Spalt (Rₛ) passt.

3. Vorrichtung nach mindestens einem der vorherigen Ansprüche, **dadurch gekennzeichnet, dass** das Dichtungselement (28, 30; 46) kugelförmig, zylindrisch, pyramidenförmig, kegelförmig und/oder ringförmig ist.

4. Vorrichtung nach mindestens einem der vorherigen Ansprüche, **dadurch gekennzeichnet, dass** das Dichtungselement (30; 46) hohl ist.

5. Vorrichtung nach Anspruch 4, wobei die Dicke der Hülle des hohlen Dichtungselementes (28, 30; 46) zwischen 100µm und 1mm beträgt.

6. Vorrichtung nach mindestens einem der vorherigen Ansprüche, **dadurch gekennzeichnet, dass** das Dichtungselement (28, 30; 46) aus Metall, Keramik und/oder Kunststoff ist.

7. Vorrichtung nach mindestens einem der vorherigen Ansprüche, **dadurch gekennzeichnet, dass** die Abmessung des Dichtungselement (28, 30; 46) zwischen 1,0 bis 10mm liegt.

8. Vorrichtung nach mindestens einem der vorherigen Ansprüche, **dadurch gekennzeichnet, dass** die Vorrichtung ein um das Dichtungselement (28, 30; 46) angeordnetes Halteelement (48) aufweist, wobei das Halteelement (48) im Abdeckbereich (12) angeordnet ist.

9. Vorrichtung nach mindestens einem der vorherigen Ansprüche, **dadurch gekennzeichnet, dass** mindestens zwei Abdeckplatten (4") die Öffnung (14) für das Bauteil (16) bilden.

10. Verfahren zum partiellen Abdecken einer Bauteilzone eines Bauteils (16) mit den Schritten:
- Platzieren des Bauteils (16) in eine zum Bauteil (16) konturnahen Öffnung (14) mindestens einer Abdeckplatte (4, 4', 4"), die einen zu beschichtenden Bereich (26) von einem abzudeckenden Bereich (24) trennt so dass die Öffnung einen minimalen Spalt (Rₛ) aufweist;
- Platzieren mindestens eines Dichtungselements (28, 30; 46) im Abdeckbereich in der Nähe der Öffnung (14) so dass der Spalt einseitig verschlossen ist, und
- Beschichten des zu beschichtenden Bereichs (26).

11. Verfahren nach Anspruch 10, wobei das Beschichten per PVD (physical vapor deposition), per CVD (chemical vapor deposition) und/oder per thermischen Spritzen erfolgt.

12. Verfahren nach mindestens einem der Ansprüche 10 bis 11, wobei vor dem Beschichten um das Dichtungselement (28, 30; 46) ein Halteelement (48) angeordnet wird.

13. Verfahren nach mindestens einem der Ansprüche 10 bis 12, wobei vor dem Beschichten ein Vakuum aufgebaut wird.
